# EUROPEAN PATENT APPLICATION

(11) **EP 1 868 231 A1**
(43) Date of publication of application: **19.12.2007**
(21) Application number: 06730368.5
(22) Date of filing: 29.03.2006
(51) Int. Cl.: H01L 21/304, B24B 7/20, B24B 49/04, B24B 49/12

(54) **BONDED WAFER MANUFACTURING METHOD, BONDED WAFER, AND PLANE POLISHING APPARATUS**

(30) Priority: 04.04.2005 JP 2005107841
(71) Applicant: Shin-Etsu Handotai Co., Ltd, Tokyo 100-0005 (JP)
(72) Inventor: OKABE, Keiichi, c/o Nagano Denshi Co., Ltd, Chikuma-shi, Nagano 3878555 (JP); TACHIKAWA, Yoshikazu, c/o Nagano Denshi Co., Ltd, Chikuma-shi, Nagano 3878555 (JP); MIYAZAKI, Susumu, c/o Nagano Denshi Co., Ltd, Chikuma-shi, Nagano 3878555 (JP); YOSHIZAWA, Sigeyuki, c/o Nagano Denshi Co., Ltd., Chikuma-shi, Nagano 3878555 (JP); TAKEI, Tokio, c/o Nagano Denshi Co., Ltd., Chikuma-shi, Nagano 3878555 (JP)
(74) Representative: Wibbelmann, Jobst
(86) International application number: PCT/JP2006/306420
(87) International publication number: WO 2006/106710

(57) **Abstract**

The present invention is a method for producing a bonded wafer, comprising at least: bonding a base wafer serving as a support substrate to a bond wafer made of a silicon single crystal via an insulator film or directly bonding the wafers to provide a bonded wafer; and reducing a thickness of the bond wafer to form a thin film made of the silicon single crystal on the base wafer, wherein the thickness of the bonded wafer is reduced based on at least surface grinding while measuring the thickness of the bond wafer, and surface grinding with respect to the bond wafer is stopped when the thickness of the bond wafer reaches a target thickness. As a result, the method for producing a bonded wafer enabling a silicon single crystal thin film to precisely have a desired film thickness, a bonded wafer, and a surface grinding machine enabling a silicon single crystal thin film to precisely have a desired film thickness are provided.

## Description

### TECHNICAL FIELD

The present invention relates to a method for producing a bonded wafer, a bonded wafer produced based on this method, and a surface grinding machine for use in formation of a thin film.

### BACKGROUND ART

As a method of fabricating an SOI wafer having an SOI (Silicon On Insulator) structure in which a silicon layer is formed on an insulator, a method of fabricating a bonded SOI wafer by bonding two of silicon single crystal wafers, which are a base wafer serving as a support substrate and a bond wafer an SOI layer is to be formed, via a silicon oxide film is known. As a process of fabricating such a bonded wafer, for example, a method of forming an oxide film on a surface of at least one of two wafers, bringing the wafers into close contact with each other without interposing foreign matters on surfaces to be bonded and then performing a heat treatment at a temperature of approximately 200 to 1200°C to enhance the bonding strength is known (see Japanese Examined Patent Publication (Kokoku) No. H5-46086).

In the bonded wafer having the bonding strength enhanced by performing such a heat treatment, when a thickness of the bond wafer is reduced to a desired thickness by grinding and polishing at a subsequent grinding and polishing step, an SOI layer where a semiconductor device is formed can be formed.

When grinding the bond wafer in this manner, a surface grinding machine (see, e.g., Japanese Patent Application Laid-open No. H11-58227) is used. This surface grinding machine includes a chuck made of, e.g., ceramics to hold the bonded wafer and a grinding wheel which is used to grind a surface of the bond wafer. Further, the rotating grinding wheel is pressed against the wafer surface while holding and rotating the bond wafer on an upper surface of the holding chuck, thereby effecting surface grinding.

At this time, a thickness of a base wafer is previously measured before bonding, and an operation of, e.g., making a laser mark on the base wafer to identify this thickness is carried out. Furthermore, a target thickness in grinding with respect to a thickness of the entire bonded wafer is set in accordance with the thickness of the base wafer. In surface grinding, grinding is carried out while measuring the thickness of the entire bonded wafer, and grinding is stopped when the entire thickness reaches the predetermined target thickness, thereby obtaining a bonded SOI wafer in which a silicon single crystal thin film (an SOI layer) having a desired thickness is formed on the base wafer via, e.g., an oxide film.

However, when this method is adopted, unevenness in thickness of the obtained silicon single crystal thin film is large, the process is complicated, and quality requirements in recent years cannot be met.

### DISCLOSURE OF INVENTION

An object of the present invention is to provide a method for producing a bonded wafer which can reduce unevenness in thickness of a silicon single crystal thin film and precisely obtain a desired film thickness, and a bonded wafer; and a surface grinding machine which can precisely obtain a desired thickness of the silicon single crystal thin film as described above.

To achieve this object, according to the present invention, there is provided a method for producing a bonded wafer, comprising at least: bonding a base wafer serving as a support substrate to a bond wafer made of a silicon single crystal via an insulator film or directly bonding the wafers to provide a bonded wafer; and reducing a thickness of the bond wafer to form a thin film made of the silicon single crystal on the base wafer, wherein the thickness of the bond wafer is reduced based on at least surface grinding while measuring the thickness of the bond wafer, and surface grinding with respect to the bond wafer is stopped when the thickness of the bond wafer reaches a target thickness.

As described above, when the thickness of the bond wafer is reduced based on at least surface grinding while directly measuring the thickness of the bond wafer and surface grinding of the bond wafer is stopped at the moment the thickness of the bond wafer reaches a target thickness, the target thickness of the silicon single crystal thin film can be further precisely obtained without being affected by a measurement error in the thickness of the base wafer.

In this case, it is preferable to perform measurement of the thickness of the bond wafer by using an optical film thickness meter.
When the thickness of the bond wafer is measured by using the optical film thickness meter in this manner, further precise thickness measurement can be performed. Therefore, the thin film having the target thickness can be formed.

In this case, when measuring the thickness of the bond wafer, it is preferable to supply water to a space between the bonded wafer to be ground and the optical film thickness meter to remove a murky liquid and provide an optically transparent state to a region between the bonded wafer to be ground and the optical film thickness meter.
As described above, in measurement of the thickness of the bond wafer, when water is supplied to the space between the bonded wafer to be ground and the optical film thickness meter to remove the murky liquid and the optically transparent state is provided to the region between the bonded wafer to be ground and the optical film thickness meter as described above, further precise thickness measurement can be performed. Therefore, the thin film having the target thickness can be formed further precisely.

Moreover, in measurement of the thickness of the bond wafer, when air is supplied to a space between the bonded wafer to be ground and the optical film thickness meter, a murky liquid can be removed.
As described above, in measurement of the thickness of the bond wafer, when air is supplied to the space between the bonded wafer to be ground and the optical film thickness meter to remove the murky liquid, the murky liquid can be readily removed, and further precise thickness measurement can be performed. Therefore, the thin film having the target thickness can be formed precisely.

Additionally, it is preferable to use a silicon single crystal wafer or an insulator wafer as the base wafer.
When the silicon single crystal wafer is used as the base wafer in this manner, an insulator film can be readily formed based on, e.g., thermal oxidation or a vapor growth method, and the base wafer can be bonded to the bond wafer via this insulator film. Further, an insulating base wafer made of, e.g., a quartz, a silicon carbide, an alumina, or a diamond may be used, and this may be directly bonded to the bond wafer.

Furthermore, according to the present invention, there is provided a bonded wafer which is produced based on any one of the above-described methods, wherein an error in a thickness of a thin film formed after surface grinding is stopped with respect to a target thickness is within ±0.3 µm.

According to the bonded wafer produced based on any one of the above-described methods in this manner, the thickness of the thin film formed after surface grinding is stopped can precisely reach the target thickness, and an error with respect to the target thickness can be readily set within ±0.3 µm. Thus, the high-quality bonded wafer having a high yield ratio and a low cost is provided.

Moreover, according to the present invention, there is provided a surface grinding machine which performs surface grinding to finish a wafer having a thin film formed on a support substrate, comprising at least: a chuck which holds the wafer; a grinding wheel which performs surface grinding with respect to a surface of the wafer; a film thickness meter which measures a thickness of the thin film on the support substrate; and a control mechanism which stops surface grinding when the thickness of the thin film measured by the film thickness meter reaches a target thickness.

As described above, when the surface grinding machine which shapes the wafer having the thin film on the support substrate based on surface grinding comprises at least: the chuck which holds the wafer; the grinding wheel which grinds the surface of the wafer; the film thickness meter which measures a thickness of the thin film on the support substrate; and the control mechanism which stops surface grinding when the thickness of the thin film measured by the film thickness meter reaches the target thickness, the thickness of the thin film can be directly measured, and grinding can be stopped upon reaching the target thickness, thereby obtaining the surface grinding machine which can precisely grind the surface of the thin film to the target thickness.

In this case, it is preferable for the film thickness meter to be an optical film thickness meter.
When the film thickness meter is the optical film thickness meter as described above, further precise thickness measurement can be performed, thus forming the thin film having the target thickness.

In this case, it is preferable to comprise means for supplying water to a space between the optical film thickness meter and the wafer.
When the means for supply water to the space between the optical film thickness meter and the wafer is comprised as described above, a region between the optical film thickness meter and the wafer can be maintained in an optically transparent state, and the thickness of the thin film can be further precisely measured, thereby forming the thin film having the target thickness.

In this case, it is preferable for the means for supplying water to comprise a cylinder which surrounds an outer periphery of the optical film thickness meter and supply water to the inside of the cylinder.
When the means for supplying water comprises the cylinder which surrounds the outer periphery of the optical film thickness meter and supplies water to the inside of the cylinder as described above, a position where water is supplied is stabilized, and the region between the optical film thickness meter and the wafer can be further assuredly maintained in the optically transparent state.

Additionally, a barrier which is arranged in such a manner that a lower end thereof is in close proximity to the surface of the wafer can be comprised between the grinding wheel and the optical film thickness meter, and the means for supplying water can supply water to the grinding wheel side of the barrier.
When the barrier which is arranged in such a manner that the lower end thereof is in close proximity to the surface of the wafer is comprised between the grinding wheel and the optical film thickness meter and the means for supplying water supplies water to the grinding wheel side of the barrier as described above, the region between the optical film thickness meter and the wafer can be maintained in an optically transparent state while conserving water.

Further, means for supplying air to a space between the optical film thickness meter and the wafer can be comprised.
When the means for supplying air to the space between the optical film thickness meter and the wafer is comprised as described above, a murky liquid can be readily removed from the space between the optical thin film meter and the wafer, and the thickness of the thin film can be precisely measured, thereby forming the thin film having the target thickness.

Furthermore, it is preferable to comprise a wafer thickness meter which measures a thickness of the entire wafer.
When the wafer thickness meter which measures the thickness of the entire wafer is comprised, the thin film can be subjected to surface grinding to reach the target thickness precisely, and the thickness of the entire wafer can be also confirmed based on measurement.

When the film thickness reduction of the bond wafer is carried out based on at least surface grinding while measuring the thickness of the bond wafer in accordance with the method for producing a bonded wafer of the present invention and surface grinding of the bond wafer is stopped at the moment the thickness of the bond wafer reaches the target thickness, unevenness can be reduced and the silicon single crystal thin film can further precisely reach the target thickness without being affected by a base wafer thickness measurement error.

Moreover, according to the bonded wafer of the present invention, the thickness of the thin film formed after surface grinding is stopped can precisely reach the target thickness and an error with respect to the target thickness can be readily set within ±0.3 µm, thereby providing the high-quality bonded wafer having a high yield ratio and a low cost.

Additionally, according to the surface grinding machine of the present invention, input setting does not have be performed every time the thickness of the base wafer is subjected to surface grinding, and the surface grinding machine which can further precisely grind the surface of the thin film to the target thickness can be provided.

### BRIEF DESCRIPTION OF DRAWINGS

FIG. 1 is a schematic view showing an example of a surface grinding machine according to the present invention;
FIG. 2 is a frequency distribution chart of an error with respect to a target thickness about a thickness of a thin film of a bonded wafer according to Example 1;
FIG. 3 is a frequency distribution chart of an error with respect to a target thickness about a thickness of a thin film of a bonded wafer according to Comparative Example 1;
FIG. 4 is a schematic view showing how a murky liquid is produced in the surface grinding machine according to the present invention;
FIG. 5 is a schematic view showing an example where means for supplying water is comprised in the surface grinding machine according to the present invention;
FIG. 6 is a schematic view showing another example where the means for supplying water is comprised in the surface grinding machine according to the present invention;
FIG. 7 is a schematic view showing still another example where the means for supplying water is comprised in the surface grinding machine according to the present invention; and
FIG. 8 is a schematic view showing an example where means for supplying air is comprised in the surface grinding machine according to the present invention.

### BEST MODES FOR CARRYING OUT THE INVENTION

The present invention will now be explained hereinafter in detail.
As described above, in a producing process of a bonded wafer, a thickness of a base wafer is measured in advance before bonding, and a target thickness for grinding about a thickness of the entire bonded wafer is set in accordance with the thickness of the base wafer. Further, in surface grinding, grinding is carried out while measuring the thickness of the entire bonded wafer. Furthermore, when the thickness of the entire wafer reaches the predetermined target thickness, stopping grinding enables obtaining a bonded SOI wafer in which a silicon single crystal thin film having a desired film thickness is formed on the base wafer via, e.g., an oxide film.

However, according to this conventional method, a thickness of each base wafer must be measured in advance, the target thickness for grinding must be set every time, and an operation of, e.g., making a laser mark which identifies the thickness of the base wafer on this wafer is required, which is complicated. Moreover, since a thickness of a bond wafer to be ground is indirectly obtained from a measurement value of the thickness of the base wafer and a measurement value of the thickness of the entire bonded wafer, a measurement error of the thickness of the base wafer and a measurement error of the thickness of the entire bonded wafer are reflected in an error of a thickness of the finally formed thin film, and unevenness occurs in the thickness of the thin film. It is to be noted that, in the conventional example, the measurement error in the thickness of the base wafer is approximately 0.2 to 0.5 µm and the measurement error in the thickness of the entire wafer is approximately 0.2 to 1 µm.

Thus, the present inventors gave thought to an idea that complication of the conventional process can be removed and the bonded wafer in which the thickness of the thin film can precisely reach the target thickness can be obtained, by reducing the thickness of the bond wafer based on at least surface grinding while measuring the thickness of the bond wafer and then stopping surface grinding wafer when the thickness of the bond wafer reaches the target thickness without calculating the thickness of the bond wafer because it is directly measured. And thus the present invention has been accomplished.

An embodiment of the present invention will now be explained hereinafter with reference to the drawings, but the present invention is not restricted thereto.

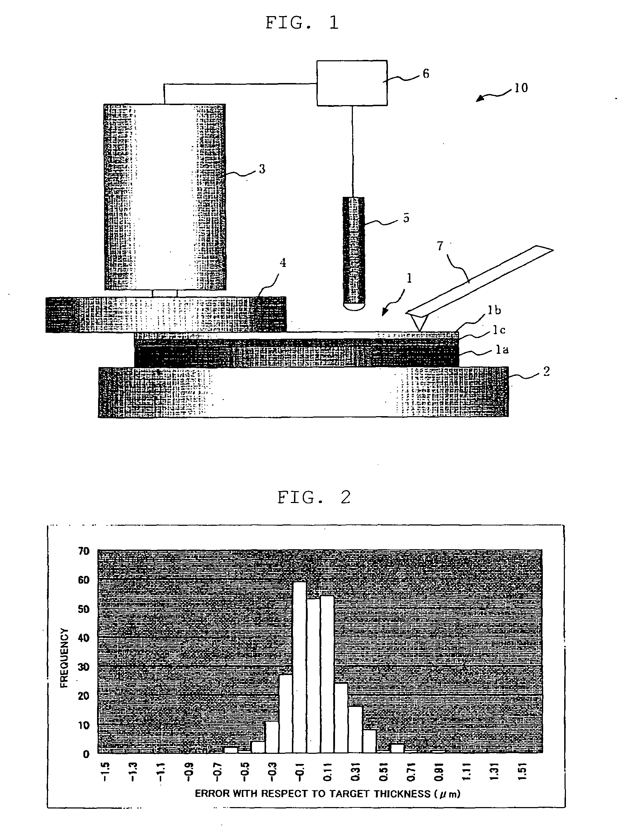

FIG. 1 is a schematic view showing an example of a surface grinding machine according to the present invention.

This surface grinding machine 10 comprises at least: a rotatable chuck 2 which holds a bonded wafer 1 fabricated by bonding a base wafer 1a serving as a support substrate and a bond wafer 1b made of a silicon single crystal via an insulator film 1c, e.g., a silicon oxide film; a rotatable grinding wheel 4 which is disposed to a grinding wheel holding portion 3 and performs surface grinding with respect to a surface of the wafer; a film thickness meter 5 which measures a thickness of a thin film (the bond wafer) on the support substrate; and a control mechanism 6 which stops surface grinding when the thickness of the thin film measured by the film thickness meter 5 reaches a target thickness, for example. When the surface grinding machine 10 has such a structure, it functions as a surface grinding machine which can precisely perform surface grinding until the thickness of the thin film reaches the target thickness.

As the chuck 2, the grinding wheel holding portion 3, and the grinding wheel 4, members prepared in a commercially available grinding machine, e.g., DFG-840 manufactured by Disco Corporation can be used.
Although the film thickness meter 5 is not restricted in particular as long as it can precisely measure a film thickness, an optical film thickness meter is preferable. Although a commercially available spectral reflectance measurement type film thickness meter can be used as the optical film thickness meter, the optical film thickness meter is not restricted in particular. If such a film thickness meter is adopted, a film thickness can be readily directly measured, a film thickness measurement error can be set to approximately 0.01 µm or below, and a measurement error can be greatly reduced as compared with an error in a thickness of the thin film when measuring a thickness of each base wafer in advance and setting a target thickness for grinding based on calculation every time in accordance with the measured thickness like the conventional method.

Moreover, if the surface grinding machine 10 also comprises a wafer thickness meter 7 which measures a thickness of the entire bonded wafer 1, the thickness of the entire wafer can be confirmed based on measurement, which is preferable. As the wafer thickness meter, for example, a general-purpose contact-type measurement head can be used.

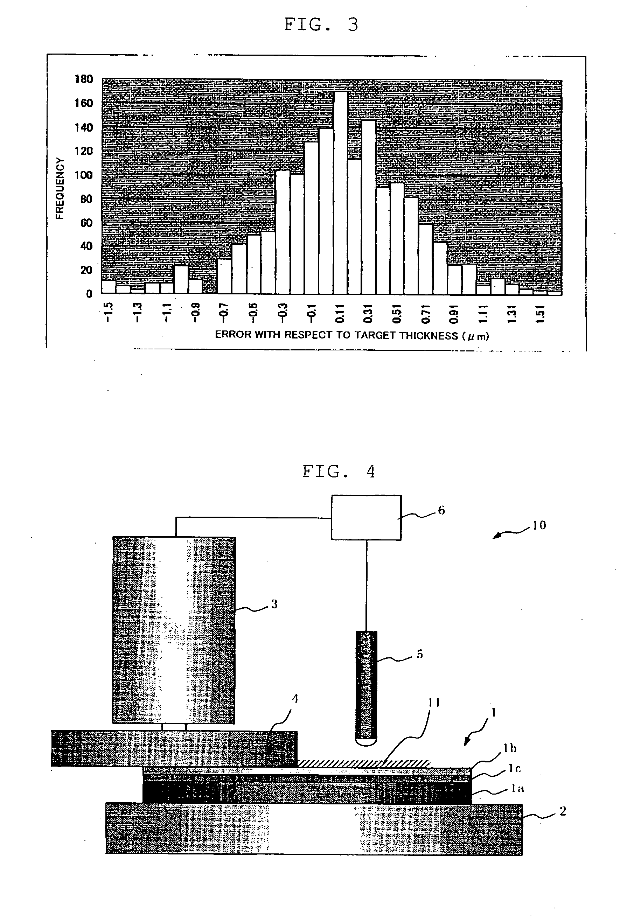

Meanwhile, since the surface grinding machine realizes a grinding speed of, e.g., 0.1 to 1 µm/second when grinding a silicon wafer, even a response error of approximately 0.1 second in a processing time has a great impact in order to realize a thickness precision of ±0.3 µm. Therefore, thickness detection in a cycle which is assuredly lower than 0.1 second, or desirably a cycle which is not greater than 0.01 second is required. That is, as shown in FIG. 4, measurement is often performed in an environment where the grinding wheel 4 rotating at a high speed spatters a murky liquid 11 having chips and grinding water mixed therein to a surface and a periphery of the wafer 1. A measurement error of the optical film thickness meter is apt to increase due to this murky liquid 11. As a factor of increasing the measurement error, for example, the optical film thickness meter cannot normally detect reflected light because of the murky liquid 11, and a frequency of occurrence of the measurement error is increased in some cases. As a result, a frequency of occurrence of a response error is increased, and a precision of grinding the bond wafer to the target thickness may be possibly lowered.
Therefore, it is desirable to increase an effective measurement frequency to reduce the measurement error of the optical film thickness meter by maintaining the surface of the wafer 1, the optical film thickness meter 5, and a region between these members in an optically transparent state.

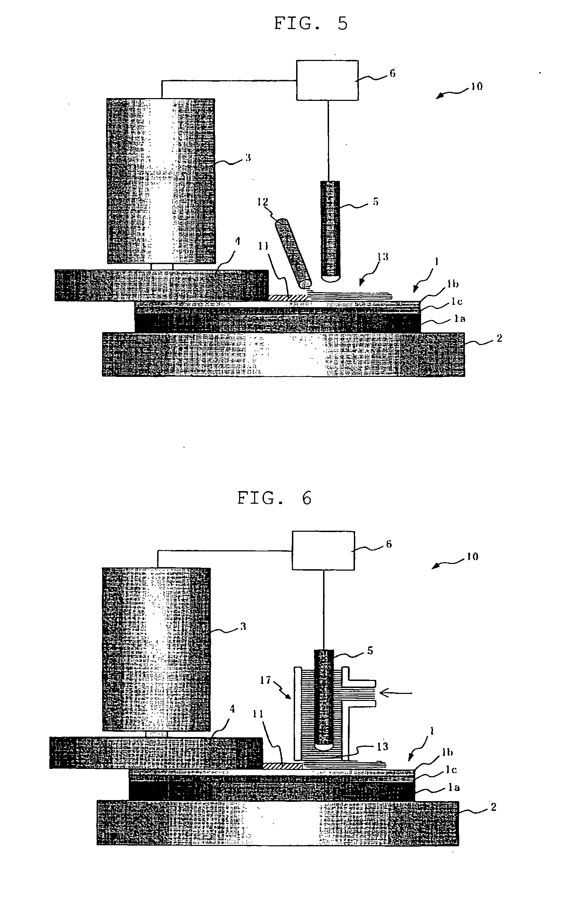

Furthermore, maintaining the surface of the wafer 1, the optical film thickness meter 5, and the region between these members in the optically transparent state in this manner can be achieved by supplying water to the region between the optical film thickness meter 5 and the wafer 1. As such means for supplying water, for example, as shown in FIG. 5, nozzle-like means for supplying water 12 can be arranged between the optical film thickness meter 5 and the grinding wheel 4.
At this time, when a temperature of water 13 to be supplied is too low, a temperature of a processing target surface is affected, and hence extra consideration for suppressing deformation of the wafer is required to perform highly precise processing. For example, it is desirable to supply water adjusted to the same temperature as that of the grinding water or a temperature allowing for an increase in temperature due to processing heat.

Moreover, as shown in FIG. 6, the means for supplying the water 13 to the region between the optical film thickness meter 5 and the wafer 1 may be a cylinder 17 which surrounds an outer periphery of the optical film thickness meter, and the water 13 may be supplied to the inside of the cylinder 17.
When the thus configured means for supplying water is adopted, a position where the water is supplied is stabilized, and the region between the optical film thickness meter and the wafer can be more assuredly maintained in the optically transparent state.

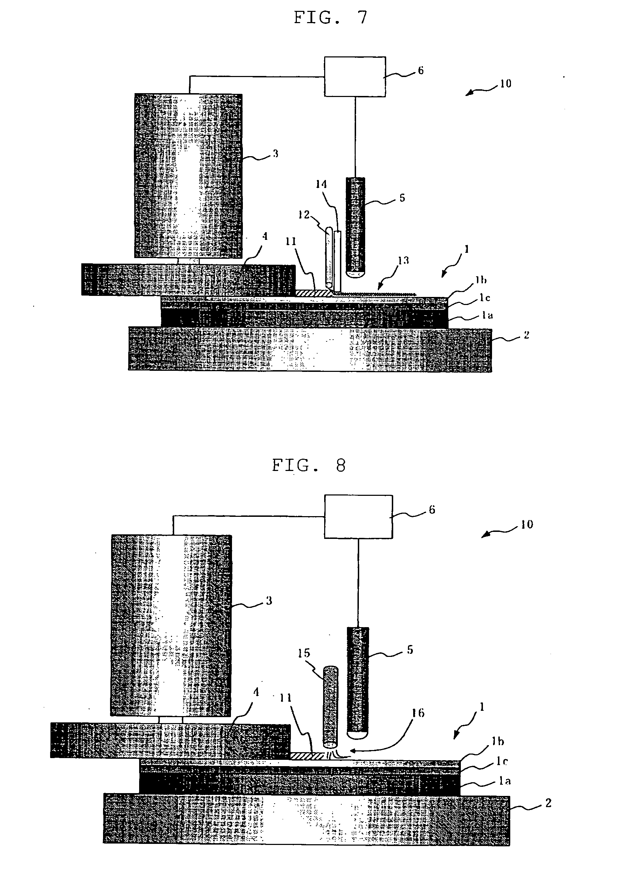

Additionally, as shown in FIG. 7, a barrier 14 whose lower end is arranged in close proximity to the surface of the wafer 1 may be arranged between the grinding wheel 4 and the optical film thickness meter 5, and the means for supplying water 12 may supply the water 13 to the grinding wheel 4 side of the barrier 14. Further, the barrier 14 may be arranged to surround the optical film thickness meter 5.
When the surface grinding machine 10 is configured in this manner, a greater part of the murky liquid 11 flowing to the optical film thickness meter 5 from a direction of the grinding wheel 4 is blocked by the barrier 14. Therefore, an amount of the water 13 which is used to remove the murky liquid 11 is reduced, thereby conserving the water.

Additionally, when a wafer grinding speed is a relatively low speed, e.g., 0.1 µm, supplying air to the region between the wafer 1 and the optical film thickness meter 5 also enables maintaining the surface of the wafer 1, the optical film thickness meter 5 and the region between these members in the optically transparent state. Although such means for supplying air is not restricted in particular, for example, nozzle-like means for supplying air 15 can be arranged between the optical film thickness meter 5 and the grinding wheel 4 as shown in FIG. 8.
When the thus configured surface grinding machine is adopted, the murky liquid 11 can be removed from the region between the wafer 1 and the optical film thickness meter 5 by using an air flow 16.
At this time, since vaporization of water occurs and a temperature of the processing target surface varies, extra consideration for suppressing deformation of the wafer is required to perform highly precise processing. For example, it is desirable to carry out temperature adjustment of compensating a reduction in a surface temperature due to vaporization heat.

Further, although the thickness of the bond wafer 1b of this bonded wafer 1 is reduced to finish the wafer having the thin film formed on the support substrate, the thickness of the bond wafer is reduced based on at least surface grinding while measuring the thickness of the bond wafer by the film thickness meter, and a grinding operation of surface grinding with respect to the bond wafer is stopped based on a stop signal from the control mechanism when the thickness of the bond wafer reaches the target thickness. When such a configuration is adopted, since the thickness of the thin film is directly measured, the silicon single crystal thin film can further precisely have the target thickness without being affected by a measurement error in the thickness of the base wafer. It is to be noted that using the optical film thickness meter to measure the thickness of the bond wafer is preferable, and the control device can stop surface grinding.

Furthermore, as described above, supplying the water or air to the region between the surface of the bonded wafer 1 and the optical film thickness meter 5 is preferable, the murky liquid 11 can be thereby removed, and the surface of the bonded wafer 1, the optical film thickness meter 1, and the region between these members can be maintained in the optically transparent state. As a result, a measurement error of the optical film thickness meter can be reduced, thus further precisely controlling the film thickness.

As the base wafer, a silicon single crystal wafer or an insulator wafer made of, e.g., a quartz, a silicon carbide, an alumina, or a diamond can be used. The bonded wafer may be fabricated by directly bonding the base wafer and the bond wafer when the base wafer is the insulator wafer.

Moreover, according to the bonded wafer produced by performing surface grinding in this manner, the thickness of the thin film formed after surface grinding is stopped can further precisely reach the target thickness, and an error with respect to the target thickness can be readily set within ±0.3 µm. That is, since the bonded wafer according to the present invention is produced while directly measuring the thickness of the bond wafer, unevenness in the thickness of the thin film caused when a measurement error in the thickness of the base wafer and a measurement error in the thickness of the entire bonded wafer are reflected in an error of the thickness of the finally formed thin film in the conventional example does not occur, the measurement error in the thickness of the bond wafer alone is reflected in the error in the thickness of the thin film, and hence the thickness of the thin film can be further precisely set to the target thickness. Therefore, the high-quality bonded wafer having a high yield ratio and a low cost can be obtained.

Although the present invention will now be specifically explained based on an example and a comparative example of the present invention, the present invention is not restricted thereto.

### (Example 1)

Two hundred sixty-five bonded wafers were fabricated, each bonded wafer having a structure where a base wafer which has a diameter of 200 mm and is made of a silicon single crystal is bonded to a bond wafer made of a silicon single crystal having a silicon oxide film formed on a surface thereof. Then, a machine obtained by combining a grinding machine DFG-840 manufactured by Disco Corporation, a general-purpose spectral reflectance measurement type film thickness meter, and a predetermined control mechanism was used as a surface grinding machine, Vitrified #325 was used as a coarse grinding wheel, Resin #2000 was used as a finishing grinding wheel, and the bond wafer of the bonded wafer was subjected to surface grinding to reduce its thickness. Surface grinding was carried out while measuring a thickness of the bond wafer (a thin film) by using the spectral reflectance measurement type film thickness meter. Further, at the same time, a general-purpose contact-type measurement head was used to measure a thickness of the entire bonded wafer. At this time, a target thickness of the thin film was set to 65 µm. When the thickness of the thin film reached the target thickness, the control mechanism stopped surface grinding with respect to the bond wafer. The thickness of the bonded wafer at this moment was approximately 740 µm.

FIG. 2 shows a frequency distribution chart of an error from the target thickness about the thickness of the thin film of the thus fabricated bonded wafer. In this example, 90% or more of the fabricated bonded wafers have an error in the thickness of the thin film which falls within ±0.3 µm with respect to the target thickness, and it was confirmed that the bond wafer was subjected to highly precise surface grinding to result in the thin film having the target thickness and a yield ratio can be increased.

### (Comparative Example 1)

One thousand six hundred thirty-six bonded wafers were fabricated like Example 1. At this time, a thickness of each base wafer was measured in advance, and a laser mark which is used to identify this thickness was provided on each base wafer. Then, a surface grinding machine which can measure a thickness of an entire regular wafer alone was used to perform surface grinding to the bond wafer of each bonded wafer to provide a thin film. Surface grinding was carried out by using a general-purpose contact-type measurement head while measuring a thickness of the entire bonded wafer. A target thickness of the entire bonded wafer was set to approximately 740 µm in accordance with the thickness of the base wafer. It is to be noted that a target thickness of the thin film in this example was set to 65 µm. Furthermore, surface grinding with respect to the bond wafer was stopped when the thickness of the entire bonded wafer reached the target thickness. Then, a thickness of the thus formed thin film was measured by using a spectral reflectance measurement type film thickness meter.

FIG. 3 shows a frequency distribution chart of an error in the thickness of the thin film of the thus fabricated bonded wafer with respect to the target thickness. In this comparative example, not only the bonded wafers each having an error in the thickness of the thin film with respect to the target thickness falling within ±0.3 µm are approximately 60% of all the wafers, but also some of the bonded wafers have an error exceeding ±1 µm, unevenness is large, and the bond wafer was not able to be subjected to precise surface grinding to obtain the thin film having the target thickness.

It is to be noted that the present invention is not restricted to the foregoing embodiment. The foregoing embodiment is just an example, and any example which has a structure substantially equal to a technical concept described in claims of the present invention and demonstrates the same functions and effects is included in a technical scope of the present invention.

For example, although the silicon single crystal wafer is used as the base wafer in the foregoing embodiment, an insulator wafer made of, e.g., a quartz, a silicon carbide, an alumina, or a diamond, as the base wafer, may be used to be directly bonded to the bond wafer made of a silicon single crystal. And, the present invention can be also applied to an example where the bond wafer is directly bonded to the base wafer without using an insulator film and the thickness of the bond wafer is reduced.

## Claims

1. A method for producing a bonded wafer, comprising at least: bonding a base wafer serving as a support substrate to a bond wafer made of a silicon single crystal via an insulator film or directly bonding the wafers to provide a bonded wafer; and reducing a thickness of the bond wafer to form a thin film made of the silicon single crystal on the base wafer, wherein the thickness of the bond wafer is reduced based on at least surface grinding while measuring the thickness of the bond wafer, and surface grinding with respect to the bond wafer is stopped when the thickness of the bond wafer reaches a target thickness.

2. The method for producing a bonded wafer according to claim 1, wherein the thickness of the bond wafer is measured by using an optical film thickness meter.

3. The method for producing a bonded wafer according to claim 2, wherein, when measuring the thickness of the bond wafer, water is supplied to a space between the bonded wafer to be ground and the optical film thickness meter to remove a murky liquid, and a region between the bonded wafer to be ground and the optical film thickness meter is maintained in an optically transparent state.

4. The method for producing a bonded wafer according to claim 2, wherein, when measuring the thickness of the bond wafer, air is supplied to a space between the bonded wafer to be ground and the optical film thickness meter to remove a murky liquid.

5. The method for producing a bonded wafer according to any one of claims 1 to 4, wherein a silicon single crystal wafer or an insulator wafer is used as the base wafer.

6. A bonded wafer which is produced based on the method according to any one of claims 1 to 5, wherein an error in a thickness of a thin film formed after surface grinding is stopped with respect to a target thickness is within ±0.3 µm.

7. A surface grinding machine which performs surface grinding to finish a wafer having a thin film formed on a support substrate, comprising at least: a chuck which holds the wafer; a grinding wheel which performs surface grinding with respect to a surface of the wafer; a film thickness meter which measures a thickness of the thin film on the support substrate; and a control mechanism which stops surface grinding when the thickness of the thin film measured by the film thickness meter reaches a target thickness.

8. The surface grinding machine according to claim 7, wherein the film thickness meter is an optical film thickness meter.

9. The surface grinding machine according to claim 8, comprising means for supplying water to a space between the optical film thickness meter and the wafer.

10. The surface grinding machine according to claim 9, wherein the means for supplying water comprises a cylinder which surrounds an outer periphery of the optical film thickness meter, and supplies water to the inside of the cylinder.

11. The surface grinding machine according to claim 9, comprising a barrier arranged between the grinding wheel and the optical film thickness meter in such a manner that a lower end thereof is arranged in close proximity to a surface of the wafer, and wherein the means for supplying water supplies water to the grinding wheel side of the barrier.

12. The surface grinding machine according to claim 8, comprising means for supplying air to a space between the optical film thickness meter and the wafer.

13. The surface grinding machine according to any one of claims 7 to 12, further comprising a wafer thickness meter which measures a thickness of the entire wafer.
